(19) Europäisches Patentamt
European Patent Office
Office européen des brevets

(11) **EP 2 348 636 B1**

(12) **FASCICULE DE BREVET EUROPEEN**

(45) Date de publication et mention de la délivrance du brevet:
**16.10.2013 Bulletin 2013/42**

(51) Int Cl.:
***H03K 17/0814*** *(2006.01)*

(21) Numéro de dépôt: **10151113.7**

(22) Date de dépôt: **19.01.2010**

(54) **Dispositif interrupteur de puissance commandé à semi-conducteurs et système interrupteur associé**

Halbleitergesteuerte Leistungsunterbrechervorrichtung und entsprechendes Unterbrechungssystem

Controlled power switching device with semiconductors and associated switching system

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(43) Date de publication de la demande:
**27.07.2011 Bulletin 2011/30**

(73) Titulaire: **Thales**
**92200 Neuilly Sur Seine (FR)**

(72) Inventeurs:
• **Lambert, Marc**
**6210 Ham-sur-heure / Nalinnes (BE)**
• **Saussez, Yves**
**7370 Blaugies (BE)**
• **Michel, Raymond**
**Montigny-le-Tilleul (BE)**

(74) Mandataire: **Esselin, Sophie et al**
**Marks & Clerk France**
**Conseils en Propriété Industrielle**
**Immeuble Visium**
**22, Avenue Aristide Briand**
**94117 Arcueil Cedex (FR)**

(56) Documents cités:
EP-A2- 0 967 721      WO-A1-96/27230
FR-A1- 2 710 803      US-A1- 2002 057 540

## Description

L'invention porte sur une pluralité N de dispositif interrupteur de puissance commandé, à semi-conducteurs et système associé de limitation de tension électrique.

Un interrupteur est un dispositif permettant d'interrompre ou de rétablir le passage du courant dans un circuit électrique par l'ouverture ou la fermeture de ce circuit.

Un interrupteur de puissance commandé à semi-conducteurs élémentaire, peut comprendre un MOSFET, acronyme de "Metal-Oxyd Semiconductor Field Effect Transistor", un IGBT, acronyme de "Isolated gate bipolar transistors", des transistors bipolaires ou tout autre composant modulant le courant qui le traverse selon un signal appliqué à son électrode de commande. Dans le cas des MOSFET et des IGBT, cette électrode est communément appelée la "grille".

L'invention peut être utilisée pour constituer un interrupteur de puissance. Dans la suite de la description, et de manière non limitative, l'invention sera décrite par des modes de réalisations comprenant des MOFSET.

Un MOFSET possède trois électrodes : une source qui peut émettre des électrons dans un canal, un drain qui recueille les électrons à l'autre extrémité du canal, et une grille dont la tension grille-source contrôle le débit d'électron.

La tension électrique de seuil intrinsèque $V_{GS\ THRESHOLD}$ ("threshold" signifiant seuil en langue anglo-saxonne) est définie comme étant la tension électrique entre la grille et la source pour laquelle la zone d'inversion apparait, c'est-à-dire la création du canal de conduction entre le drain et la source. Plus on augmente cette tension électrique au-delà du seuil $V_{GS\ THRESHOLD}$, plus le composant peut laisser passer de courant. Si l'on applique une tension électrique grille-source $V_{GS}$ inférieure à ce seuil, le composant ne laisse pas passer de courant entre le drain et la source. Ceci est vrai tant que la tension électrique drain-source $V_{ds}$ reste inférieure à la tension électrique drain-source maximale $V_{dss}$ que peut supporter le MOFSET lorsqu'il est bloqué. La valeur de cette tension électrique est spécifiée par le fabriquant. La valeur fournie correspond à cette tension électrique maximale $V_{dss}$, en l'absence de tension électrique grille-source (court—circuit). Son sigle usuel est $V_{dss}$ (pour $V_{ds}$ "shorted" en langue anglo-saxonne). Si l'on dépasse cette tension électrique maximale $V_{dss}$, le MOSFET laisse passer du courant électrique, mais peut être détruit lors de ce passage.

Bien que certains composants soient conçus pour supporter une mise en conduction fugitive par dépassement de la tension électrique maximale $V_{dss}$, il est préférable de ne pas appliquer cette tension électrique au composant car, à un passage de courant électrique avec une tension électrique importante, correspond une puissance importante dissipée dans le composant. Celle-ci peut communiquer au composant une énergie dépassant l'énergie maximale qu'il peut emmagasiner et donc le détruire.

Par ailleurs, dans certains domaines d'application, tel que le domaine spatial, des règles de conceptions imposent de rester nettement en-deçà de cette tension maximale, généralement en-deçà de 80% de cette tension maximale.

Enfin, les composants à semi- conducteur sont sensibles aux particules énergisées, tels des ions lourds. Ces ions lourds sont présents dans l'environnement spatial. La conception des équipements destinés aux lanceurs astronautiques ou fusées, aux satellites, aux stations orbitales, aux sondes et autres véhicules spatiaux, doit impérativement tenir compte de ces rayonnements.

Pour les MOSFET, cette sensibilité apparaît lorsque la tension électrique $V_{ds}$ appliquée entre le drain et la source dépasse un seuil propre à chaque modèle de composant. L'impact d'une particule énergisée sur un MOSFET subissant une tension électrique drain-source $V_{ds}$ supérieure au seuil de sensibilité peut provoquer sa destruction. Il existe des MOSFET qualifiés de "durcis", ou "radiation hardened" ou "RadHard" en langue anglo-saxonne, résistant aux particules énergisées. Leur prix de revient est de cinq cents à mille fois supérieur à celui des composants ordinaires.

Comme précédemment indiqué, la vulnérabilité des composants apparaît lorsque la tension électrique qu'ils subissent dépasse une tension électrique de seuil. Ainsi, à titre d'exemple, un MOSFET ordinaire, non durci, spécifié pour une différence de tension électrique $V_{ds}$ entre le drain et la source maximale $V_{dss}$ de 100 V, est insensible aux particules énergisées lorsque que la tension électrique $V_{ds}$ entre le drain et la source reste inférieure à 50 V.

Pour des composants ordinaires, le rapport entre la tension électrique maximale admissible et la tension électrique maximale pour laquelle ils sont insensibles aux particules énergisées, décroît avec la tension maximale autorisée : de 50 à 65% pour un MOSFET de $V_{dss}$ de 100V, contre 45% pour un MOSFET de $V_{dss}$ de 400V. Par contre, la résistance électrique intrinsèque $R_{dson}$ du MOFSET croît avec la tension $V_{dss}$ maximale admissible.

Les documents "Paralleling Of Power MOSFETs For Higher Power Output" de James B. Forsythe, "Application Note AN-941 Paralleling HEXFET Power MOSFETs", "Parallel Connection of IGBT and MOSFET Power Modules" de Serge Bontemps, et "Analysis of Avalanche Behaviour for Paralleled MOSFETs" de Jingdong Chen, Scott Downer, Anthony Murray, et David Divins, divulguent des mises en parallèle d'interrupteurs élémentaires, tels des MOSFET, ou IGBT.

La thèse "Le transistor MOSFET en commutation : Application aux associations série et parallèle de composants à grille isolée." d'Pierre-Olivier JEANNIN défendue à l'Institut National Polytechnique de Grenoble présente l'état de l'art pour les mises en série ou parallèle de composants interrupteurs. Elle ne présente pas de combinaisons série et parallèle simultanées.

Les documents suivants donnent l'état de l'art pour la mise en série de composants interrupteurs : "Suitability and Optimization of High-Voltage IGBTs for Series Connection With Active Voltage Clamping" Friedhelm Bauer, Member, IEEE, Luc Meysenc, Member, IEEE, and Alice Piazzesi, Member, IEEE in IEEE TRANSACTIONS ON POWER ELECTRONICS, VOL. 20, NO. 6, NOVEMBER 2005, "Active Voltage Control of IGBTs for High Power Applications" Patrick R. Palmer, Member, IEEE, and Haile S. Rajamani in IEEE TRANSACTIONS ON POWER ELECTRONICS, VOL. 19, NO. 4, JULY 2004, "Optimisation and integration of an active clamping circuit for IGBT series association." J. Saiz, M. Mermet D. Frey, P.O. Jeannin, JL. Schanen Member IEEE, P. Muszicki in IEEE Volume 2, Issue, 30 Sep-4 Oct 2001 Page(s):1046 - 1051 vol.2.

Ces documents divulguent toujours des dispositifs de limitation de tension électrique qui ne gèrent qu'un composant et exploitent celui-ci par une action sur son électrode de commande. Ce type de solution n'est pas utilisable pour des composants montés en parallèle, car le composant ayant le seuil de limitation le plus bas sera le seul à effectuer cette limitation ce qui entraine un déséquilibre des dissipations entre les éléments montés en parallèle.

Ces documents ne divulguent pas d'interrupteurs élémentaires montés en parallèle pour lesquels on peut garantir que leur tension électrique reste inférieure à une valeur inférieure à leur tension électrique maximale entre le drain et la source $V_{dss}$.

Un but de l'invention est de proposer un dispositif interrupteur de puissance commandé à semi-conducteurs, résistant au cas de panne simple de court-circuit et ayant une durée de fonctionnement améliorée (par diminution des charges en tension, courant et puissance, imposées aux composants), utilisant une mise en série et en parallèle d'interrupteurs élémentaires, pour lequel on peut garantir que leur tension électrique $V_{ds}$ reste inférieure à une valeur inférieure à une tension électrique choisie, afin qu'il convienne à des applications requérant cette condition.

Aussi, selon l'invention, il est proposé un système interrupteur comprenant une pluralité N de dispositifs interrupteurs de puissance commandé à semi- conducteurs disposés en série, un dispositif interrupteur de puissance commandé à semi- conducteur comprenant :

- un circuit de commande capable d'effectuer un décalage de tension électrique et une adaptation du signal en tension et en courant ;
- une pluralité d'interrupteurs élémentaires à semi-conducteurs montés en parallèle ; et
- un circuit commun de limitation de tension électrique pour maintenir la tension électrique aux bornes desdits interrupteurs élémentaires inférieure à une tension électrique de seuil inférieure à la tension électrique maximale intrinsèque d'un interrupteur élémentaire, ledit circuit commun de limitation étant disposé en parallèle desdits interrupteurs élémentaires caractérisé en ce que N respecte la relation :

$$(N-1) \times S > V$$

dans laquelle :

S représente une tension électrique de seuil d'un dispositif interrupteurs de puissance commandés à semi-conducteur (Di); et
V représente une tension électrique maximale admissible aux bornes du système interrupteur (Si)

en implémentant un dispositif de plus qu'il n'est nécessaire pour supporter la tension maximale aux bornes du système interrupteur permettant au système interrupteur de rester fonctionnel en cas de panne ou court-circuit de n'importe lequel des dispositifs interrupteurs de puissance commandé à semi-conducteurs (Di) de la pluralité composant le système interrupteur (Si).

Ainsi, il est possible de garantir que la tension électrique aux bornes d'un interrupteur élémentaire ne dépasse jamais une tension électrique de seuil, fixée lors de la conception, ce qui garantit, à coût réduit, une grande fiabilité du dispositif interrupteur pour des applications nécessitant une telle contrainte, telles des convertisseurs de tension, des systèmes de commande de moteur, des actionneurs électriques, fiables dans les domaines spatial, aéronautique, nucléaire, militaire, naval, sous- marin.

Dans le mode de réalisation, un interrupteur élémentaire comprend un transistor à effet de champ à grille métal-oxyde.

Prendre des transistors à effet de champ à grille métal-oxyde comme interrupteurs élémentaires permet de proposer un dispositif interrupteur de puissance commandé à semi-conducteurs, adapté pour être utilisé dans un lanceur en résistant aux particules énergisées.

Selon le mode de réalisation, ledit circuit commun de limitation comprend un circuit dérivateur de courant électrique et un générateur de signal de commande dudit circuit dérivateur.

Ainsi, il est aisé de réaliser un circuit commun de limitation, de coût réduit.

Dans le mode de réalisation, ledit circuit dérivateur de courant électrique comprend un transistor à effet de champ à grille métal-oxyde, et ledit générateur de signal de commande dudit circuit dérivateur comprend un module pour assurer une référence constante de tension électrique et un amplificateur de la différence entre la tension électrique appliquée aux bornes du dispositif interrupteur et ladite tension électrique de référence.

Par exemple, le module pour assurer une référence constante de tension électrique peut comprendre une diode Zener, et l'amplificateur peut comprendre un transistor.

De tels circuits dérivateur et générateur, en limitant la tension avec précision permettent de réduire les marges de conception ; ils permettent aussi d'améliorer la gestion des flux thermiques en répartissant les pertes : celles liées à la commutation sont bien réparties sur chaque interrupteur élémentaire et celles liées à la limitation de tension sont dissipées par le circuit dérivateur.

Le système interrupteur comprend, en outre, un circuit d'amortissement d'oscillations, par exemple, comprenant une résistance et un condensateur montés en série.

Un tel circuit d'amortissement d'oscillations permet de limiter la vitesse de variation de la tension appliquée et offre un second lieu pour dissiper l'énergie stockée dans les inductances parasites et, ce, de manière efficace, à un coût réduit.

Selon l'invention, il est proposé un système interrupteur comprenant une pluralité N de dispositifs interrupteurs de puissance commandés à semi-conducteurs, tels que décrits précédemment, disposés en série.

Ainsi, aucune tension électrique aux bornes d'un dispositif interrupteur du système interrupteur ne dépasse une tension maximale.

Cette disposition permet d'augmenter la tension maximale que peut supporter le système interrupteur.

Dans le mode de réalisation, N respecte la relation:

$$(N-1)\times S > V$$

dans laquelle :

S représente une tension électrique de seuil d'un dispositif interrupteurs de puissance commandés à semi-conducteur (DI) ; et
V représente une tension électrique maximale admissible aux bornes du système interrupteur (SI).

Ainsi, on prévoit un dispositif interrupteur de plus qu'il n'est nécessaire pour supporter la tension maximale aux bornes du système interrupteur, ce qui rend le système interrupteur résistant à une panne en court-circuit de l'un de ses dispositifs interrupteurs. Même si une telle panne devait se produire, le dispositif reste capable d'interrompre le courant qui le traverse et de supporter la tension maximale qui lui est appliquée. Le coût relatif de cette adjonction étant inversement proportionnel à N, elle est particulièrement intéressante pour N > 2.

En outre, le système d'interrupteur comprend un circuit de récupération d'énergie, par exemple, comprenant un ensemble de quatre diodes montées dans le même sens, disposé en parallèle à ladite pluralité de dispositifs interrupteurs de puissance commandé à semi-conducteurs, ledit ensemble de quatre diodes comprenant deux sous-ensembles de deux diodes montées en parallèle, montés en série.

Ce circuit de récupération est particulièrement intéressant lorsque deux systèmes interrupteurs, tels que précédemment décrit, sont montés en série afin de constituer une branche d'onduleur ou de hacheur en pont.

Ainsi, lors des périodes de récupération ou "roue libre", le courant emprunte ces diodes et non des diodes placées sur les dispositifs interrupteurs ou les diodes intrinsèques à ces dispositifs. Ainsi, d'une part, les pertes énergétiques sont plus faibles puisque la chute de tension est limitée à celle de deux diodes en série, contrairement au cas d'une utilisation de plusieurs diodes étagées, et sont dissipées dans ces quatre diodes au lieu des dispositifs interrupteurs, ce qui facilite la gestion des flux thermiques ; d'autre part, la présence de ces quatre diodes permet, le cas échéant, d'éviter la mise en conduction des diodes intrinsèques des interrupteurs élémentaires tels les MOSFET, ce qui réduit les pertes dues au recouvrement des diodes intrinsèques et diminue la sensibilité du composant aux brusques variations de tension électrique présentes lors de la commutation.

Selon le mode de réalisation, ledit circuit de récupération d'énergie comprend un ensemble de quatre diodes montées dans le même sens, disposé en parallèle à ladite pluralité de dispositifs interrupteurs de puissance commandés à semi-conducteurs, ledit ensemble de quatre diodes comprenant deux sous-ensembles de deux diodes montées en parallèle, montés en série.

Cette disposition est destinée à rester fonctionnelle en cas de panne d'une des diodes, qu'il s'agisse d'une panne en court-circuit ou en circuit ouvert.

Selon l'invention, il est également proposé un onduleur de commande d'un moteur synchrone multi phase comprenant, par phase, deux systèmes interrupteurs tels que précédemment décrits.

Un tel onduleur est donc particulièrement adapté à un lanceur.

Le document EP 0 967 721 A2 décrit un circuit de protection pour un système interrupteur comprenant une pluralité N de dispositifs interrupteurs utilisé dans une application de conversion d'énergie.

L'invention sera mieux comprise à l'étude de quelques modes de réalisation, décrits à titre d'exemples nullement limitatifs, et illustrés par les dessins annexés sur lesquels :

- la figure 1 illustre schématiquement un dispositif interrupteur de puissance commandé à semi-conducteurs, selon un aspect de l'invention ;
- la figure 2 illustre schématiquement un exemple de réalisation d'un dispositif interrupteur de la figure 1, selon un aspect de l'invention ;

- la figure 3 illustre schématiquement un système interrupteur comprenant une pluralité de dispositifs interrupteurs de la figure 1 ou 2, selon un aspect de l'invention ;
- la figure 4 illustre schématiquement un exemple de réalisation d'un système interrupteur de la figure 3, selon un aspect de l'invention ;
- la figure 5 illustre un onduleur comprenant une pluralité de systèmes interrupteurs de la figure 3 ou 4, selon un aspect de l'invention.

Sur les différentes figures, les éléments ayant des références identiques sont identiques.

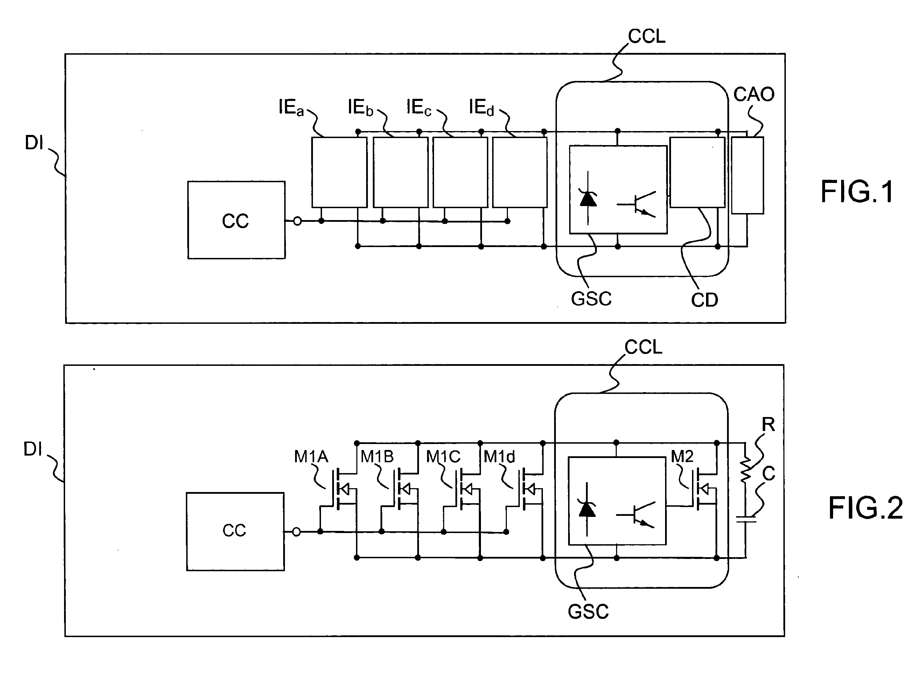

Sur la figure 1 est représenté un dispositif interrupteur de puissance DI commandé à semi-conducteurs comprenant un circuit de commande CC capable d'effectuer un décalage de tension électrique et une adaptation en courant électrique et tension électrique, afin de correspondre aux caractéristiques requises pour la commande de l'élément de puissance en courant électrique et tension électrique. Ce circuit est caractérisé par sa capacité à fournir, au dispositif interrupteur, un signal de commande, acceptant une tension électrique de mode commun élevée, positive ou négative, par exemple de -100V ou de +400V. La tension électrique de mode commun d'un élément fournissant une tension différentielle entre deux points, est classiquement définie comme étant la tension électrique commune à ces deux points qui ne contient pas d'information. Le dispositif interrupteur de puissance DI comprend également une pluralité d'interrupteurs élémentaires à semi-conducteurs montés en parallèle, en l'espèce quatre interrupteurs élémentaires IEa, IEb, IEc et IEd.

Le dispositif interrupteur de puissance DI comprend également un circuit commun de limitation CCL pour maintenir la tension électrique, aux bornes des interrupteurs élémentaires IEa, IEb, IEc et IEd, inférieure à une tension électrique de seuil S inférieure à la tension électrique maximale intrinsèque d'un interrupteur élémentaire, le circuit commun de limitation CCL étant disposé en parallèle desdits interrupteurs élémentaires IEa, IEb, IEc et IEd.

Par exemple, le circuit commun de limitation CCL comprend un circuit dérivateur de courant électrique CD et un générateur de signal de commande GSC dudit circuit dérivateur CD.

En outre, est représenté un circuit optionnel d'amortissement d'oscillations CAO permettant d'absorber l'énergie présente dans les inductances parasites et, ce faisant, de limiter la vitesse de variation de la tension électrique dans le dispositif interrupteur DI.

Un tel dispositif interrupteur permet de disposer d'un interrupteur de puissance, capable de fonctionner à des tensions élevées par rapport à sa tension de commande, qui préserve ses interrupteurs élémentaires en assurant le respect de la tension maximale choisie lors de la conception et qui répartit le flux thermique entre ses composants. La limitation de la tension maximale permet de préserver les composants et permet d'en obtenir une meilleure longévité.

La figure 2 représente un mode de réalisation d'un dispositif interrupteur DI de la figure 1, dans lequel un interrupteur élémentaire IEa, IEb, IEc, IEd comprend un transistor à effet de champ à grille métal-oxyde ou MOSFET ordinaires M1 a, M1b, M1c, M1d.

Le circuit dérivateur de courant électrique CD comprend comme élément de puissance un transistor à effet de champ à grille métal-oxyde ou MOFSET M2, et le générateur de signal de commande GSC du circuit dérivateur CD comprend un module pour assurer une référence constante de tension électrique, par exemple une diode Zener et un amplificateur qui convertit la différence entre la tension électrique appliquée aux bornes du dispositif interrupteur DI et la tension électrique de référence, en une tension de commande de l'élément de puissance du circuit dérivateur CD.

Le MOFSET M2 du circuit dérivateur CD est normalement bloqué ou OFF. Lorsque le générateur de signal de commande GSC détecte une tension électrique aux bornes des MOSFET ordinaires M1a, M1b, M1c, M1d, approchant la tension de seuil S, il met le MOFSET M2 en conduction contrôlée, qui ne correspond pas à une mise en conduction franche ou ON, mais à un fonctionnement en source de courant. Cette source de courant combinée aux impédances présentes dans le drain du MOSFET M2 permet de réguler la tension électrique aux bornes du dispositif interrupteur DI. Une fois la tension électrique redescendue en dessous de la tension électrique de seuil S, le générateur de signal de commande GSC rebloque le MOSFET M2.

Le circuit commun de limitation CCL assure une limitation de la tension électrique aux bornes des MOSFET ordinaires M1a, M1b, M1c, M1d durant les états OFF du dispositif interrupteur DI, en maintenant celle-ci sous la valeur de tension électrique de seuil S. La présence d'une surtension fugace pendant la commutation du dispositif interrupteur DI, ne réduit quasiment pas l'immunité aux particules énergisées, car la durée des moments de vulnérabilité est faible en regard de la durée totale des cycles de fonctionnement.

En outre, le circuit d'amortissement d'oscillations CAO comprend une résistance R et un condensateur C montés en série.

Ce mode de réalisation est particulièrement avantageux pour une utilisation dans un lanceur astronautique, car il permet de réduire drastiquement le coût d'un dispositif interrupteur, comparé à un dispositif utilisant des MOSFET durcis, d'un coût d'achat et de montage de 500 à 1000 fois supérieur au coût d'achat et de montage d'un MOSFET ordinaire.

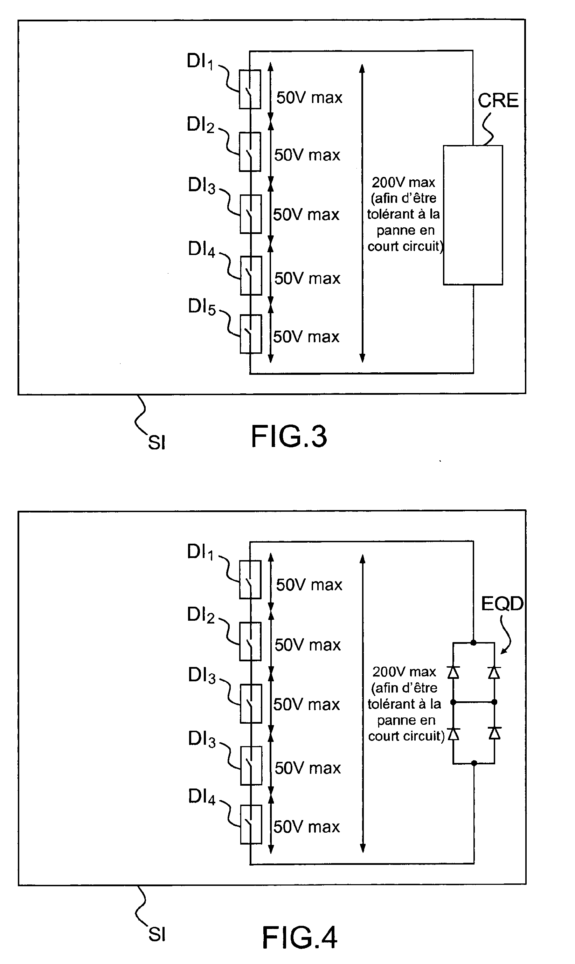

La figure 3 représente un système interrupteur SI comprenant une pluralité de dispositifs interrupteurs DI de puissance commandés à semi-conducteurs, en l'occurrence cinq $DI_1$, $DI_2$, $DI_3$, $DI_4$, et $DI_5$.

Un circuit optionnel de récupération d'énergie CRE est représenté, et peut, dans un mode de réalisation préférentiel, illustré sur la figure 4, comprendre un ensemble de quatre diodes montées dans le même sens, disposé en parallèle à ladite pluralité de dispositifs interrupteurs de puissance commandés à semi-conducteurs. L'ensemble de quatre diodes comprend deux sous-ensembles de deux diodes montées en parallèle, les deux sous-ensembles étant montés en série.

Dans le cadre d'une utilisation pour des lanceurs, il est indispensable que chaque dispositif interrupteur ne subisse pas une tension électrique supérieure à une tension choisie en l'espèce la tension électrique de seuil S.

Dans le présent exemple, les composants constituant les dispositifs interrupteurs DI d'un système interrupteur SI peuvent supporter une tension de 50V en restant insensibles à l'environnement radiatif.

Il est également souhaitable qu'une panne en court-circuit d'un des dispositifs interrupteurs DI ne perturbe pas le fonctionnement d'un système interrupteur SI auquel il appartient. Les quatre dispositifs interrupteurs restés fonctionnels pouvant, dans le présent exemple particulièrement adapté à un lanceur, supporter chacun 50 V, la tension maximale admissible pour le système interrupteur est de 200 V.

Pratiquement, la tension électrique maximale sera inférieure à 200 V car il faut tenir compte d'une marge d'erreur sur la valeur de la limitation de tension électrique protégeant les dispositifs interrupteurs DI. Ainsi, une tolérance de $\pm$ 5% sur une limitation à 47, 5 V (de 45 V à 50 V) limitera la tension électrique totale applicable à 4*45 V = 180 V.

Notons que lorsque les cinq dispositifs interrupteurs $DI_1$, $DI_2$, $DI_3$, $DI_4$, et $DI_5$ sont opérationnels, le partage de tension électrique n'est pas forcement équitable et ne doit pas l'être. Si quatre dispositifs interrupteurs supportent 45 V et le dernier 20 V, la condition de tension inférieure à 50 V par dispositif interrupteur est respectée.

De manière plus générale, pour un système interrupteur SI selon l'invention, comprenant une pluralité N de dispositifs interrupteurs de puissance commandés à semi-conducteurs DI tels que décrits précédemment, pour résister à une panne en court-circuit d'un des dispositifs interrupteurs DI, le système interrupteur SI doit respecter la relation suivante :

$$(N\text{-}1) \times S > V$$

dans laquelle :

S représente une tension électrique de seuil d'un dispositif interrupteurs de puissance commandés à semi-conducteur (DI) ; et
V représente une tension électrique maximale admissible aux bornes du système interrupteur (SI).

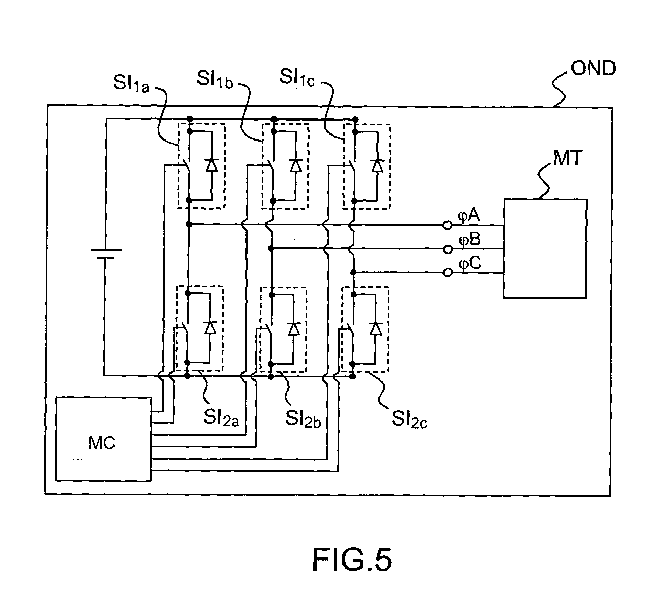

Notons également le montage du circuit de récupération d'énergie CRE, disposé en parallèle du montage ne série de la pluralité de dispositifs interrupteurs $DI_1$, $DI_2$, $DI_3$, $DI_4$, et $DI_5$. Dans le mode de réalisation de la figure 4, le circuit de récupération d'énergie CRE est réalisé avec un ensemble de quatre diodes tel que précédemment décrit, ou "quad" de diodes monté en parallèle sur l'ensemble de l'interrupteur. Elle est par-contre fondamentale pour un système d'interrupteur SI d'onduleur, tel qu'illustré sur la figure 5.

Il y a deux buts à cette disposition des quatre diodes :

- réduire les pertes lorsque ce "quad" de diodes est conducteur. En effet, la tension électrique de conduction du système interrupteur SI est celle de deux diodes montées en série et non celles des cinq diodes intrinsèques des dispositifs interrupteurs DI, particulièrement lorsqu'ils comprennent des MOSFET. La tension de chute est donc plus faible.
- éviter que les diodes intrinsèques, ou "body diode" en langue anglo-saxonnes, des MOSFETS constituant les dispositifs interrupteurs DI ne deviennent conductrices. Cela permet d'éviter de devoir respecter les temps de récupération de ces diodes et permet de soumettre, sans risque, le MOSFET à des $dV_{ds}/dt$ importants.

Un exemple d'utilisation de tels systèmes interrupteurs SI, est illustré dans un onduleur sur la figure 5, représentant un onduleur adapté à un lanceur astronautique, comprenant un module de commande MC, un moteur triphasé MT à trois phases φA, φB, et φC.

La phase φA est commandée par l'intermédiaire de deux systèmes d'interrupteurs $SI_{1a}$ et $SI_{2a}$ des figures 3 ou 4, la phase φB est commandée par l'intermédiaire de deux systèmes d'interrupteurs $SI_{1b}$ et $SI_{2b}$ des figures 3 ou 4, et la phase φC est commandée par l'intermédiaire de deux systèmes d'interrupteurs $SI_{1c}$ et $SI_{2c}$ des figures 3 ou 4.

**Revendications**

1. Système interrupteur (SI) comprenant une pluralité N de dispositifs interrupteurs de puissance commandés à semi-conducteurs (DI) disposés en série, un dispositif interrupteur de puissance commandé à semi-conducteurs (DI) comprenant :

     - un circuit de commande (CC) capable d'effectuer un décalage de tension électrique et une adaptation en courant électrique et tension électrique ;
     - une pluralité d'interrupteurs élémentaires à semi-conducteurs (IEa, IEb, IEc, IEd) montés en parallèle ; et
     - un circuit commun de limitation de tension électrique (CCL) pour maintenir la tension électrique aux bornes desdits interrupteurs élémentaires (IEa, IEb, IEc, IEd) inférieure à une tension électrique de seuil (S) inférieure à la tension électrique maximale intrinsèque d'un interrupteur élémentaire (IEa, IEb, IEc, IEd), ledit circuit commun de limitation (CCL) étant disposé en parallèle desdits interrupteurs élémentaires (IEa, IEb, IEc, IEd) ;

**caractérisé en ce que** N respecte la relation :

$$(N-1) \times S > V$$

dans laquelle :

S représente une tension électrique de seuil d'un dispositif interrupteurs de puissance commandés à semi-conducteur (DI) ; et
V représente une tension électrique maximale admissible aux bornes du système interrupteur (SI)

en implémentant un dispositif de plus qu'il n'est nécessaire pour supporter la tension maximale aux bornes du système interrupteur permettant au système interrupteur de rester fonctionnel en cas de panne en court-circuit de n'importe lequel des dispositifs interrupteurs de puissance commandé à semi-conducteurs (DI) de la pluralité composant le système interrupteur (SI).

2. Système interrupteur (SI) selon la revendication 1, dans lequel un interrupteur élémentaire (IEa, IEb, IEc, IEd) comprend un transistor à effet de champ à grille métal-oxyde (M1a, M1b, M1c, M1d).

3. Système interrupteur (SI) selon la revendication 1 ou 2, dans lequel ledit circuit commun de limitation (CCL) comprend un circuit dérivateur de courant électrique (CD) et un générateur de signal de commande (GSC) dudit circuit dérivateur (CD).

4. Système interrupteur (SI) selon la revendication 3, dans lequel ledit circuit dérivateur de courant électrique (CD) comprend un transistor à effet de champ à grille métal-oxyde (M2), et ledit générateur de signal de commande (GSC) dudit circuit dérivateur (CD) comprend des moyens pour assurer une référence constante de tension électrique et un amplificateur de la différence entre la tension électrique appliquée aux bornes du dispositif interrupteur (DI) et ladite tension électrique de référence.

5. Système interrupteur (SI) selon l'une des revendications précédentes, comprenant, en outre, un circuit d'amortissement d'oscillations (CAO).

6. Système interrupteur (SI) selon la revendication 5, dans lequel ledit circuit d'amortissement d'oscillation comprend une résistance (R) et un condensateur (C) montés en série.

7. Système interrupteur selon l'une des revendications précédentes, comprenant, en outre, un circuit de récupération d'énergie (CRE).

8. Système interrupteur selon la revendication 7, dans lequel ledit circuit de récupération d'énergie (CRE) comprend un ensemble de quatre diodes montées dans le même sens, disposé en parallèle à ladite pluralité de dispositifs interrupteurs de puissance commandés à semi-conducteurs (DI1, DI2, DI3, DI4, DI5), ledit ensemble de quatre diodes comprenant deux sous-ensembles de deux diodes montées en parallèle, montés en série.

9. Onduleur de commande (OND) d'un moteur synchrone multi phase **caractérisé en ce qu'**il comprend, par phase, deux systèmes interrupteurs selon l'une des revendications précédentes.

**Patentansprüche**

1. Unterbrechersystem (SI), das eine Vielzahl N von durch in Reihe angeordneten Halbleitern gesteuerten Leistungsunterbrechervorrichtungen (DI) umfasst, wobei eine halbleitergesteuerte Leistungsunterbrechervorrichtung (DI) umfasst:

- einen Steuerkreis (CC), der imstande ist, eine elektrische Spannungsverschiebung und eine Anpassung des elektrischen Stroms und der elektrischen Spannung durchzuführen,
- eine Vielzahl elementarer Unterbrecher mit Halbleitern (IEa, IEb, IEc, IEd), die parallel geschaltet sind, und
- einen gemeinsamen Begrenzungskreis der elektrischen Spannung (CCL), um die elektrische Spannung an den Klemmen der elementaren Schalter (IEa, IEb, IEc, IEd) unter einer elektrischen Grenzspannung (S) zu halten, die niedriger ist als die maximale inhärente elektrische Spannung eines elementaren Unterbrechers (IEa, IEb, IEc, IEd), wobei der gemeinsame Begrenzungskreis (CCL) parallel zu den elementaren Unterbrechern (IEa, IEb, IEc, IEd) angeordnet ist,

**dadurch gekennzeichnet, dass** N die Relation einhält:

$$(N-1) \times S > V$$

wobei:

S eine elektrische Grenzspannung einer halbleitergesteuerten Leistungsunterbrechervorrichtung (DI) darstellt, und
V eine an den Klemmen des Unterbrechersystems (SI) maximal zulässige elektrische Spannung darstellt,

unter Implementierung einer Vorrichtung mehr als notwendig, um die maximale Spannung an den Klemmen des Unterbrechersystems zu vertragen, was dem Unterbrechersystem erlaubt, bei einer Kurzschlusspanne irgend einer der halbleitergesteuerten Leistungsunterbrechervorrichtungen (DI) der Vielzahl, die das Unterbrechersystem (SI) bildet, funktional zu bleiben.

2. Unterbrechersystem (SI) nach Anspruch 1, wobei ein elementarer Unterbrecher (IEa, IEb, IEc, IEd) einen Feldeffekt-Transistor mit Metalloxidgitter (M1a, M1b, M1c, M1d) umfasst.

3. Unterbrechersystem (SI) nach Anspruch 1 oder 2, wobei der gemeinsame Begrenzungskreis (CCL) einen Abzweigkreis des elektrischen Stroms (CD) und einen Steuersignalerzeuger (GSC) des Abzweigkreises (CD) umfasst.

4. Unterbrechersystem (SI) nach Anspruch 3, wobei der Abzweigkreis des elektrischen Stroms (CD) einen Feldeffekt-Transistor mit Metalloxidgitter (M2) umfasst, und der Steuersignalerzeuger (GSC) des Abzweigkreises (CD) Mittel umfasst, um eine konstante Referenz der elektrischen Spannung sicherzustellen und einen Verstärker der Differenz zwischen der an den Klemmen der Unterbrechervorrichtung (DI) anliegenden elektrischen Spannung und der elektrischen Referenzspannung.

5. Unterbrechersystem (SI) nach einem der vorangehenden Ansprüche, das ferner einen Schwingungsdämpfungskreis (CAO) umfasst.

6. Unterbrechersystem (SI) nach Anspruch 5, wobei der Schwingungsdämpfungskreis einen Widerstand (R) und einen Kondensator (C) umfasst, die in Reihe geschaltet sind.

7. Unterbrechersystem nach einem der vorangehenden Ansprüche, das ferner einen Energierückgewinnungskreis (CRE) umfasst.

8. Unterbrechersystem nach Anspruch 7, wobei der Energierückgewinnungskreis (CRE) eine Gruppe von vier in dieselbe Richtung montierten Dioden umfasst, die parallel zur der Vielzahl der halbleitergesteuerten Leistungsunterbrechervorrichtungen (DI1, DI2, DI3, DI4, D15) angeordnet ist, wobei die Gruppe von vier Dioden zwei Untergruppen von zwei parallel montierten Dioden umfasst, die in Reihe montiert sind.

9. Steuer-Wechselrichter (OND) eines Mehrphasen-Synchronmotors, **dadurch gekennzeichnet, dass** er je Phase zwei Unterbrechersysteme nach einem der vorangehenden Ansprüche umfasst.

## Claims

1. A switching system (SI) comprising a plurality N of power controlled semi-conductor switching devices (DI) disposed in series, a power controlled semi-conductor switching device (DI) comprising:

- a control circuit (CC) designed to carry out an offset of electric voltage and a matching of electric current and electric voltage;
- a plurality of elementary semi-conductor switches (IEa, IEb, IEc, IEd) mounted in parallel; and
- a common electric voltage limiting circuit (CCL) for maintaining the electric voltage on the terminals of said elementary switches (IEa, IEb, IEc, IEd) below an electric voltage with a threshold (S) below the maximum intrinsic electric voltage of an elementary switch (IEa, IEb, IEc, IEd), said common limiting circuit (CCL) being disposed in parallel to said elementary switches (IEa, IEb, IEc, IEd);

**characterised in that** N complies with the following relation:

$$(N-1)xS>V$$

in which:

S represents an electric voltage threshold of a power controlled semi-conductor switching device (DI); and
V represents a maximum permissible electric voltage on the terminals of said switching system (SA)

by implementing one more device than is necessary for supporting the maximum voltage at the terminals of said switching system, allowing said switching system to remain operational in the event of a short-circuit failure of any of the power controlled semi-conductor switching devices (DI) of the plurality of power controlled semi-conductor switching devices composing said switching system (SI).

**2.** The switching system (SI) according to claim 1, wherein an elementary switch (IEa, IEb, IEc, IEd) comprises a metal-oxide gate field effect transistor (M1a, M1b, M1c, M1d).

**3.** The switching system (SI) according to claim 1 or 2, wherein said common limiting circuit (CCL) comprises an electric current differentiating circuit (CD) and a control signal generator (GSC) of said differentiating circuit (CD).

**4.** The switching system (SI) according to claim 3, wherein said electric current differentiating circuit (CD) comprises a metal-oxide gate field effect transistor gate (M2), and said control signal generator (GSC) of said differentiating circuit (CD) comprises means for providing a constant electric voltage reference and an amplifier of the difference between the electric voltage applied to the terminals of the switching device (DI) and said reference electric voltage.

**5.** The switching system (SI) according to any one of the preceding claims, further comprising an oscillation damping circuit (CAO).

**6.** The switching system (SI) according to claim 5, wherein said oscillation damping circuit comprises a resistor (R) and a condenser (C) mounted in series.

**7.** The switching system according to any one of the preceding claims, further comprising an energy recovery circuit (CRE).

**8.** The switching system according to claim 7, wherein said energy recovery circuit (CRE) comprises a set of four diodes mounted in the same direction, disposed in parallel to said plurality of power controlled semi-conductor switching devices (DI1, DI2, DI3, DI4, DI5), said set of four diodes comprising two subsets of two diodes mounted in parallel, mounted in series.

**9.** A control inverter (OND) for a multi-phase synchronous motor, **characterised in that** it comprises, per phase, two switching systems according to any one of the preceding claims.

FIG.1

FIG.2

DI$_1$

50V max

DI$_2$

50V max

DI$_3$

50V max

DI$_4$

50V max

DI$_5$

50V max

CRE

200V max
(afin d'être
tolérant à la
panne en
court circuit)

SI

## FIG.3

DI$_1$

50V max

DI$_2$

50V max

DI$_3$

50V max

DI$_3$

50V max

DI$_4$

50V max

EQD

200V max
(afin d'être
tolérant à la
panne en
court circuit)

SI

## FIG.4

**FIG.5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0967721 A2

**Littérature non-brevet citée dans la description**

- **DE JAMES B. FORSYTHE.** Paralleling Of Power MOSFETs For Higher Power Output. *Application Note AN-941 Paralleling HEXFET Power MOSFETs*
- **FRIEDHELM BAUER ; LUC MEYSENC ; ALICE PIAZZESI.** Suitability and Optimization of High-Voltage IGBTs for Series Connection With Active Voltage Clamping. *IEEE TRANSACTIONS ON POWER ELECTRONICS,* Novembre 2005, vol. 20 (6
- **PATRICK R. PALMER ; HAILE S. RAJAMANI.** Active Voltage Control of IGBTs for High Power Applications. *IEEE TRANSACTIONS ON POWER ELECTRONICS,* Juillet 2004, vol. 19 (4
- **J. SAIZ ; M. MERMET ; D. FREY ; P.O. JEANNIN ; JL. SCHANEN.** Optimisation and integration of an active clamping circuit for IGBT series association. *Optimisation and integration of an active clamping circuit for IGBT series association,* 04 Septembre 2001, vol. 2 (30), 1046-1051